# EUROPÄISCHE PATENTANMELDUNG

(11) **EP 1 137 180 A1**
(43) Veröffentlichungstag der Anmeldung: **26.09.2001**
(21) Anmeldenummer: 00106223.1
(22) Anmeldetag: 22.03.2000
(51) Int. Cl.: H03K 5/1252

(54) **Digitales Tiefpassfilter für digitale Signale und Verfahren zur Verarbeitung eines digitalen Signales**

(71) Anmelder: Infineon Technologies AG, 81669 München (DE)
(72) Erfinder: Nolles, Jürgen, 81541 München (DE); Kniffler, Oliver, 81737 München (DE); Guo, Shuwei, Dr., 81737 München (DE)
(74) Vertreter: Hermann, Uwe, Dipl.-Ing.

(57) **Zusammenfassung**

Ein digitales Tiefpaßfilter für digitale Signale besitzt einen Flankendetektor (ED), einen Zähler (BC) und einen Zustandsspeicher (FSM). Der Zähler wird durch ein Taktsignal (clk) weitergeschaltet und bei Detektion einer Flanke durch den Flankendetektor (ED) wieder zurückgesetzt. Bei Anliegen eines Eingangssignales (IN) mit einer definierten minimalen Impulsdauer erreicht der Zählerstand einen charakteristischen Wert (N), der den Zustandsspeicher veranlaßt, den Pegel des Eingangssignales als Ausgangssignal auszugeben.

## Beschreibung

Die Erfindung betrifft ein digitales Tiefpaßfilter für digitale Signale sowie ein Verfahren zur Verarbeitung von digitalen Signalen. Tiefpaßfilter werden oft dann eingesetzt, wenn aus einem Nutzsignal kurze Störsignale ausgefiltert werden sollen, da solche Störsignale Fehler verursachen können. Tiefpaßfilter sind in der Regel als Analogfilter aufgebaut. Ihre grundlegende Struktur ist beispielsweise aus "U. Tietze, Ch. Schenk: Halbleiterschaltungstechnik, Springer-Verlag, 11. Auflage, Seite 1350 ff." bekannt. Bei analogen Filtern besteht das Problem, daß je nach Auslegung des Filters neben den Störsignalen auch das Nutzsignal verändert wird. Bei der Einbettung eines analogen Filters in einen Halbleiterchip sind die Filtereigenschaften zudem stark von der Herstellungstechnologie abhängig. Darüberhinaus sind analoge Filter nicht programmierbar, sondern die Filterparameter sind nur hardwaretechnisch einstellbar.

Aufgabe der vorliegenden Erfindung ist es daher, ein digitales Tiefpaßfilter anzugeben, der die o.g. Probleme der Nutzsignalbeeinflussung nicht aufweist, programmierbar und darüber hinaus einfach im Aufbau ist. Außerdem soll ein Verfahren angegeben werden, mit dem sich digitale Signale einfach filtern lassen.

Die erste Aufgabe wird gelöst durch ein digitales Tiefpaßfilter für digitale Systeme mit einem Flankendetektor, dessen Eingang mit einem Anschluß für ein Filter-Eingangssignal mit zwei möglichen Pegeln verbunden ist, einem Zähler, der einen Eingang für ein Taktsignal und einen mit dem Flankendetektor verbundenen Reset-Eingang aufweist, einem zwei Zustände aufweisenden Zustandsspeicher, der mit dem Zähler und dem Anschluß für ein Filter-Eingangssignal verbunden ist, wobei durch den Zustand des Zustandsspeichers der Pegel eines Ausgangssignals des Filters bestimmt ist, und wobei der Zustandsspeicher bei Erreichen eines festlegbaren Zählerstandes einen von den Pegeln des Eingangssignales abhängenden Zustand einnimmt.

Ein derartiges Tiefpaßfilter verzögert das Eingangssignal so lange, bis der Zähler den festlegbaren Zählerstand erreicht hat. Nach dieser Zeitspanne ist klar, daß es sich bei dem momentan anliegenden Pegel nicht um ein Störsignal handelt, sondern um ein Nutzsignal. Infolgedessen wird das Eingangssignal nun als Ausgangssignal weiter gegeben.

Ein erfindungsgemäßes Verfahren zur Verarbeitung eines digitalen Signales gliedert sich in zwei Teilverfahren, wobei in einem ersten Teilverfahren eine Zählervariable bei einer Flanke des Eingangssignales auf einen Startwert gesetzt und anschließend die Zählervariable durch ein vorgegebenes Taktsignal schrittweise erhöht oder erniedrigt wird, und einem zweiten Teilverfahren, in dem eine zwei mögliche Werte aufweisende Zustandsvariable bei Erreichen eines festlegbaren Zählerstandes auf einen vom dem Signalzustand des Eingangssignales abhängenden Wert gesetzt wird, und wobei durch den Wert der Zustandsvariablen der Signalzustand eines Ausgangssignales bestimmt wird.

In vorteilhaften Ausführungen ist die Periodendauer des Taktsignales kleiner als die minimale Impulsdauer eines zu erwartenden Nutzsignales. Vorteilhaft ist es, wenn die Periodendauer des Taktsignales mindestens 10 mal kleiner als die minimale Impulsdauer des zu erwartenden Nutzsignales ist.

Weitere Einzelheiten und Ausgestaltungen der Erfindung sind in den Unteransprüchen angegeben.

Die Erfindung wird nachfolgend an einem Ausführungsbeispiel anhand der Zeichnungen näher erläutert. Es zeigt:
Figur 1 ein Blockschaltbild eines erfindungsgemäßen Tiefpaßfilters,
Figur 2 ein Zustandsdiagramm des Zustandsspeichers des Tiefpaßfilters von Figur 1 und
Figur 3 die zeitlichen Signalverläufe eines Tiefpaßfilters gemäß den Figuren 1 und 2.

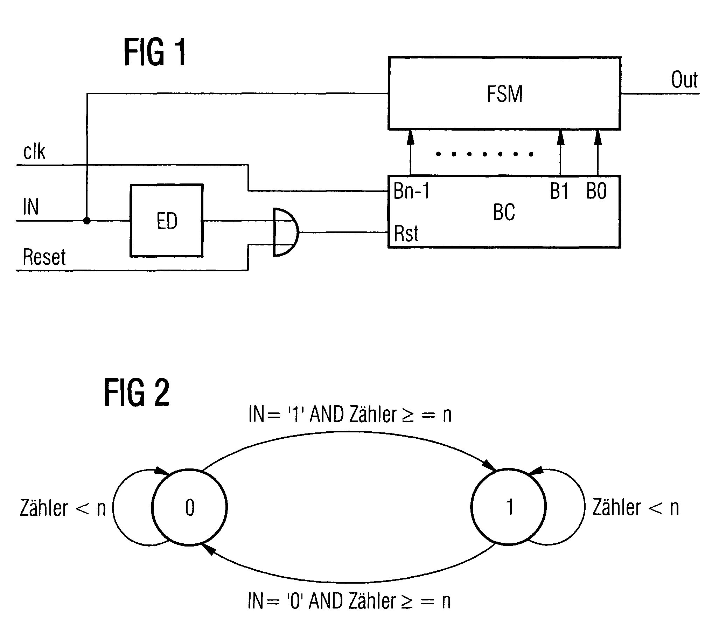

Bei einem digitalen Tiefpaßfilter gemäß der Figur 1 liegt ein Eingangssignal IN an einem Flankendetektor ED an. Zudem ist das Eingangssignal IN auf einen Zustandsspeicher FSM geschaltet. Der Ausgang des Flankendetektors ED ist in Figur 1 über eine ODER-Verknüpfung mit einem Reset-Eingang eines Zählers BC verbunden. Der Zähler besitzt einen Takteingang, an dem ein Taktsignal clk anliegt. Eine Flanke des Eingangssignales IN wird durch den Flankendetektor ED festgestellt, so daß dieser ein entsprechendes Signal an den Reset-Eingang des Zählers BC übermittelt. Die ODER-Verknüpfung ermöglicht die Einkopplung eines externen Reset-Signales. Dadurch wird der Zähler BC auf einen Startwert gesetzt. Durch das Taktsignal am Takteingang CLK wird der Zählerstand schrittweise erhöht. In einer anderen erfindungsgemäßen Ausführungsform könnte der Zählerstand auch erniedrigt werden. Durch die Anordnung mit dem Zähler BC und dem Flankendetektor ED ist eine Zeitbasis realisiert, denn der Zähler BC kann einen Wert N nur dann erreichen, wenn die Dauer eines Impulses des Eingangssignales IN mindestens N ^{*} T_{clk} andauert. Bei kürzerer Dauer des Impulses wird der Zähler BC durch die abfallende Flanke des Impulses bzw. die ansteigende Flanke des nächsten Impulses wieder zurück gesetzt. Anhand des Zählerstandes des Zählers BC ist also erkennbar, wie lange ein Impuls des Eingangssignales dauert. Dies bezieht sich nicht nur auf den HIGH-Pegel, sondern ebenso auf den LOW-Pegel. Präziser formuliert kann man sagen, daß anhand des Zählerstandes des Zählers BC erkennbar ist, wie lange ein Signalzustand des Eingangssignales IN vorliegt. Die Zeitmessung ist umso genauer, je kürzer die Peroidendauer T_{clk} des Taktsignales ist und desto größer dadurch der Wert N wählbar ist.

Die Information des Zählerstandes wird an den Zustandsspeicher FSM übergeben. Der Zustandsspeicher FSM ist so ausgelegt, daß ein an seinem Eingang anliegendes Filter-Eingangssignal IN dann als Ausgangssignal OUT weiter geschaltet wird, wenn der Zählerstand den festlegbaren Wert N erreicht. Das Filter-Ausgangssignal OUT folgt also dem Filter-Eingangssignal IN mit einer definierten Verzögerung, die ungefähr N ^{*} T_{clk} entspricht.

Das Umschalten der Zustände des Zustandsspeichers FSM ist anhand der Figur 2 verdeutlicht. Als Anfangszustand wird angenommen, daß sich der Zustandsspeicher FSM im Zustand "0" befindet. Solange der Zählerstand nicht den festlegbaren Wert N erreicht, bleibt der Zustandsspeicher in diesem Zustand. Erst wenn am Filtereingang ein HIGH-Signal anliegt und der Zählerstand den Wert N erreicht, wird der Wert des Zustandsspeichers FSM auf "1" gesetzt. In diesem Zustand verbleibt der Zustandsspeicher FSM wiederum, so lange der Zählerstand BC den Wert N nicht erreicht. Erst bei Anliegen eines LOW-Signals am Filtereingang und einem Zählerstand größer oder gleich N schaltet der Zustandsspeicher FSM in den Zustand "0" zurück.

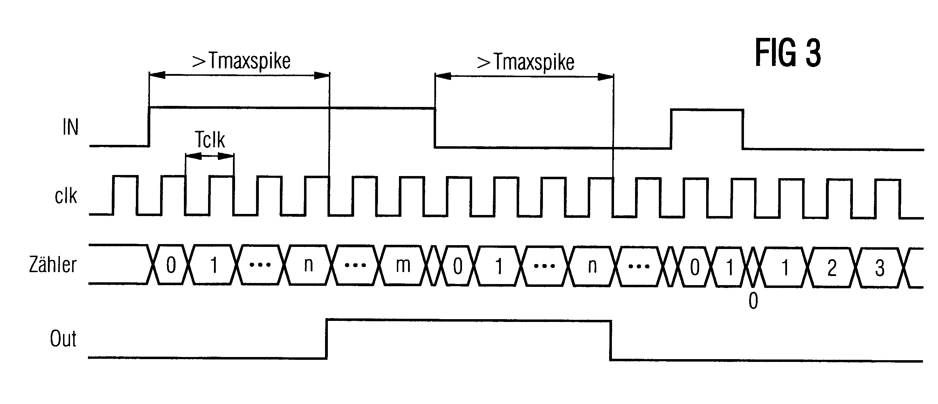

Die Bedeutung für die Verarbeitung eines Signales am Filtereingang IN ist anhand der Figur 3 dargestellt. Der digitale Tiefpaßfilter soll Signale unterhalb einer bestimmten Zeitdauer als Störsignale ausfiltern und Signale, die länger andauern, als Nutzsignale passieren lassen. Als Grenzwert zwischen Störsignal und Nutzsignal ist eine Impulsdauer Tₘₐₓₛₚᵢₖₑ definiert. Signale, die kürzer als Tₘₐₓₛₚᵢₖₑ anliegen, sind demnach Störsignale und Signale, die länger anliegen, sind als Nutzsignale einzustufen. Die Länge des Eingangsimpulses ist über die Anzahl der Taktperioden des darunter dargestellten Taktsignales feststellbar. Im vorliegenden Beispiel wäre n also mit 3 zu bemessen, so daß also mit Erreichen des Zählerstandes 3 ein Nutzsignal vorliegt. Normalerweise ist das Eingangssignal nicht synchron mit dem Taktsignal. Die Verzögerung zwischen dem Eingangssignal und dem Durchschalten auf den Filterausgang liegt also zwischen N ^{*} T_{clk} und (N + 1) ^{*} T_{clk}. Entsprechendes gilt für die Festlegung von Tₘₐₓₛₚᵢₖₑ. Die Betrachtung des Filter-Ausgangssignals OUT zeigt also, daß der erste Impuls mit HIGH-Pegel als Nutzsignal zu werten ist und demnach das Signal am Filter-Ausgang nach Tₘₐₓₛₚᵢₖₑ auf HIGH springt. Mit der fallenden Flanke dieses ersten Impulses wird der Zähler zurückgesetzt und beginnt bei "0" neu zu zählen. Auch der Impuls mit LOW-Pegel dauert länger als Tₘₐₓₛₚᵢₖₑ an, so daß auch dieses Signal nach Tₘₐₓₛₚᵢₖₑ auf den Ausgang weiter geschaltet wird. Der nächste Impuls mit HIGH-Pegel dauert jedoch nur eine Taktperiode des Taktsignales clk an, so daß dieser als Störimpuls gewertet wird und das Signal nicht am Filterausgang als Ausgangssignal OUT erscheint.

Wenn man annimmt, daß die Frequenz des Taktsignales 100 MHz beträgt, ergibt sich daraus eine Periodendauer T_{CLK} des Taktsignales von 10 ns. Weiterhin wird beispielsweise angenommen, daß die maximale Dauer eines Störimpulses 100 ns betragen soll. Daher muß der Wert N des Zählerstandes, bei dem ein Impuls des Eingangssignales IN als Nutzsignal erkannt wird, zu N = 10 festgelegt werden. In diesem Fall würde ein Eingangspuls mit einer Dauer größer als 110 ns = (N+1) * T_{clk} auf den Ausgang weiter geschaltet werden und Impulse, die kürzer als 100 ns = N ^{*} T_{clk} anliegen, würden unterdrückt werden. Imulse mit einer Dauer zwischen 100 ns und 110 ns können je nach Phasenlage zu dem Taktsignal als Störimpuls ausgefiltert oder als Nutzsignal auf den Ausgang weiter geschaltet werden.

Der Zähler BC des digitalen Tiefpaßfilters ist in einer vorteilhaften Ausführung als n-bit Binärzähler ausgelegt. Aber auch andere Zählervarianten sind denkbar. Üblicherweise wird der Zähler auf einen Startwert von Null zurückgesetzt, wenn ein entsprechendes Signal am Reset-Eingang anliegt. Es kann auch ein Rückwärts-Zähler eingesetzt werden, der bei einem anderen Startwert beginnt und dann bis Null zurückzählt. Wie in der Figur 1 gezeigt, kann für den Filter ein zusätzlicher Reset-Eingang vorgesehen werden, der über eine ODER-Verknüpfung mit dem Ausgangssignal des Flankendetektors ED verknüpft ist. Das durch das digitale Tiefpaßfilter durchgeführte Verfahren kann neben einer hardwaretechnischen Realisierungsform auch eine softwaretechnische Realisierungsform annehmen. Dabei können sämtliche Komponenten des Filters softwaretechnisch dargestellt werden, oder aber Teile des Filters, beispielsweise der Flankendetektor, hardwaremäßig ausgeführt und der Rest des Filters softwaremäßig realisiert sein.

## Patentansprüche

1. Digitales Tiefpaßfilter für digitale Signale mit
- einem Flankendetektor (ED), dessen Eingang mit einem Anschluß für ein Filter-Eingangssignal (IN) mit zwei möglichen Pegeln (L, H) verbunden ist,
- einem Zähler (BC), der einen Eingang für ein Taktsignal (clk) und einen mit dem Flankendetektor (ED) verbundenen Reset-Eingang aufweist,
- einem zwei Zustände (0, 1) aufweisenden Zustandsspeicher (FSM), der mit dem Zähler (BC) und dem Anschluß für ein Filter-Eingangssignal (IN) verbunden ist, wobei durch den Zustand (0, 1) des Zustandsspeichers (FSM) der Pegel (L, H) eines Ausgangssignales (OUT) des Filters bestimmt ist, und
- wobei der Zustandsspeicher (FSM) bei Erreichen eines festlegbaren Zählerstandes (N) einen von dem Pegel (L, H) des Eingangssignales (IN) abhängenden Zustand (0, 1) einnimmt.

2. Digitales Tiefpaßfilter nach Anspruch 1,
**dadurch gekennzeichnet, daß**
die Periodendauer des Taktsignales (T_{clk}) kleiner als die minimale Impulsdauer (Tₘₐₓₛₚᵢₖₑ) eines Nutzsignales ist.

3. Digitales Tiefpaßfilter nach Anspruch 2,
**dadurch gekennzeichnet, daß**
die Periodendauer des Taktsignales (T_{clk}) mindestens zehnmal kleiner als die minimale Impulsdauer (Tₘₐₓₛₚᵢₖₑ) des Nutzsignales ist.

4. Verfahren zur Verarbeitung eines digitalen Signales mit
- einem ersten Teilverfahren, bei dem eine Zählvariable bei einer Flanke eines Eingangssignales (IN) auf einen Startwert gesetzt und anschließend die Zählvariable durch ein vorgegebenes Taktsignal (clk) schrittweise erhöht/erniedrigt wird,
- einem zweiten Teilverfahren, in dem eine zwei mögliche Werte (0, 1) aufweisende Zustandsvariable bei Erreichen eines festlegbaren Wertes (N) des Zählers auf einen von dem Signalzustand (L, H) des Eingangssignales abhängenden Wert (0, 1) gesetzt wird, und wobei durch den Wert der Zustandsvariablen der Signalzustand (L, H) eines Ausgangssignales (OUT) bestimmt wird.

5. Verfahren nach Anspruch 4,
**dadurch gekennzeichnet, daß**
die Periodendauer des Taktsignales (T_{clk}) kleiner als die minimale Impulsdauer (Tₘₐₓₛₚᵢₖₑ) eines Nutzsignales ist.

6. Verfahren nach Anspruch 5,
**dadurch gekennzeichnet, daß**
die Periodendauer des Taktsignales (T_{clk}) mindestens zehnmal kleiner als die minimale Impulsdauer (Tₘₐₓₛₚᵢₖₑ) des Nutzsignales ist.
